# EUROPEAN PATENT APPLICATION

(11) **EP 1 187 340 A2**
(43) Date of publication of application: **13.03.2002**
(21) Application number: 01120647.1
(22) Date of filing: 30.08.2001
(51) Int. Cl.: H03M 13/29

(54) **Error correction apparatus equipped with turbo decoder**

(30) Priority: 30.08.2000 JP 2000261574
(71) Applicant: Kabushiki Kaisha Toshiba, Tokyo 105-8001 (JP)
(72) Inventor: Nonin, Katsuya, Minato-ku, Tokyo 105-8001 (JP)
(74) Representative: HOFFMANN - EITLE

(57) **Abstract**

An error correction apparatus includes a receiving section (101) that receives a signal. An amplifier section (102) amplifies the signal received by the receiving section (101). An automatic gain control section (105) generates a control signal and controls the gain of the amplifier section (102) based on the generated control signal so as to maintain the amplified received signal at a predetermined level. A turbo decoder (108) is configured to execute an error correction process on the received signal to thereby output a decoding result of the executed received signal, based on the generated control signal.

## Description

The present invention relates to an error correction apparatus equipped with a turbo decoder.

There are known various types of error correction apparatus that execute error correction and decoding on a string of signals received via a transmission line with an error. A turbo decoder, which is formed of two recursive decoders coupled to each other, repeatedly executes error correction to thereby enhance its error correction ability. This turbo decoder is an error correction system suitable for space communication, satellite communication and mobile communication, etc.

In the case of a turbo decoder using a LOG MAP, when calculating a path metric during a decoding process, the signal-to-interference ratio (SIR) of a reception signal, i.e. Es/No, is required. In the usual radio communication, however, it is difficult to estimate the Es/No of a currently received signal, and therefore the path metric is calculated on the basis of a fixed Es/No value.

If the Es/No is fixed and a reception signal is at a low level, an automatic gain control function is exerted to increase the gain of the reception signal. At this time, the level of noise contained in the signal is also increased. Therefore, an inaccurate weight calculation is executed during the calculation of the path metric, which degrades the error correction ability.

It is the object of the invention to provide an error correction apparatus that can maintain its error correction ability at a high level.

To attain the object, there is provided an error correction apparatus comprising:
a receiving section configured to receive a signal;
an amplifier section configured to amplify the received signal received by the receiving section;
an automatic gain control section configured to generate a control signal and to control a gain of the amplifier section based on the generated control signal, so as to maintain the amplified received signal at a predetermined level; and
a turbo decoder configured to execute an error correction process on the received signal to thereby output a decoding result of the executed received signal based on the generated control signal.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a schematic block diagram illustrating the structure of a receiver to which an error correction apparatus according to the invention is applied;
FIG. 2 is a block diagram illustrating the structure of a turbo decoder 108, according to a first embodiment of the invention, which appears in FIG. 1;
FIG. 3 is a block diagram illustrating the structure of a turbo decoder according to a second embodiment of the invention;
FIG. 4 is a block diagram illustrating the structure of a soft-input/soft-output decoder 302 (307);
FIG. 5 is a view illustrating the structure of an ACS section commonly employed in a forward ACS section 401 and a backward ACS section 402;
FIG. 6 is a block diagram illustrating the structure of a Log likelihood calculating section 403; and
FIG. 7 is a block diagram illustrating a structure according to a third embodiment of the invention.

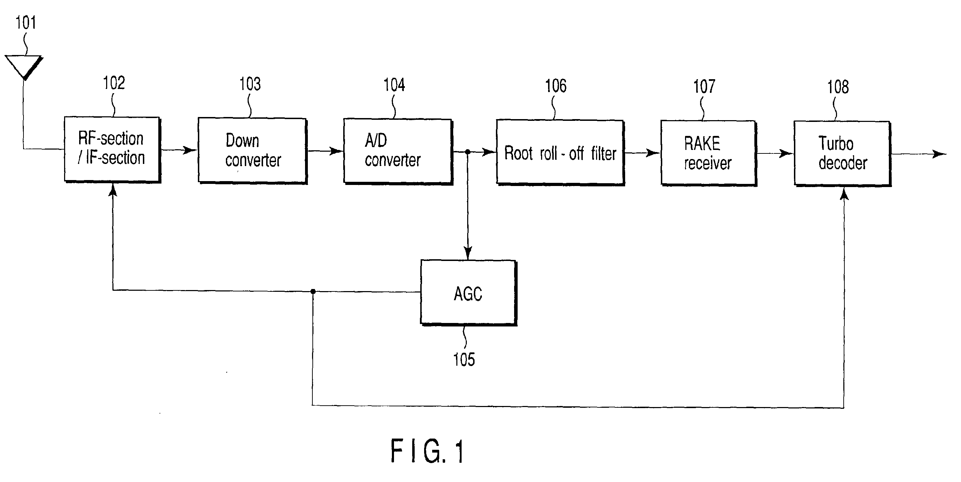

The embodiments of the invention will be described in detail with reference to the accompanying drawings. FIG. 1 is a schematic block diagram illustrating the structure of a receiver for CDMA communication, to which an error correction apparatus according to the invention is applied. A signal received by an antenna 101 has its level amplified into an appropriate value by an RF-section/IF-section 102. Subsequently, a down converter 103 converts the signal into a baseband signal, and then an A/D converter 104 converts the baseband signal into a digital signal. An AGC (Automatic Gain Control section) 105 obtains the average level of a signal output from the A/D converter 104 for a predetermined time period, and compares the average level with a preset reference value. If the average level is higher than the reference value, the AGC 105 reduces the gain of an amplifier incorporated in the IF section 102. If, on the other hand, the average level is lower than the reference value, the AGC 105 increases the gain of an amplifier incorporated in the IF section 102.

A root roll-off filter 106 filters the digital signal output from the A/D converter 104. After that, a RAKE receiver 107 executes back-diffusion/rake-synthesis process on the filtered signal. Then, a turbo decoder 108 executes error correction on the resultant signal.

Control data used by the AGC 105 is supplied to the turbo decoder 108 and used in the error correction process.

### (First Embodiment)

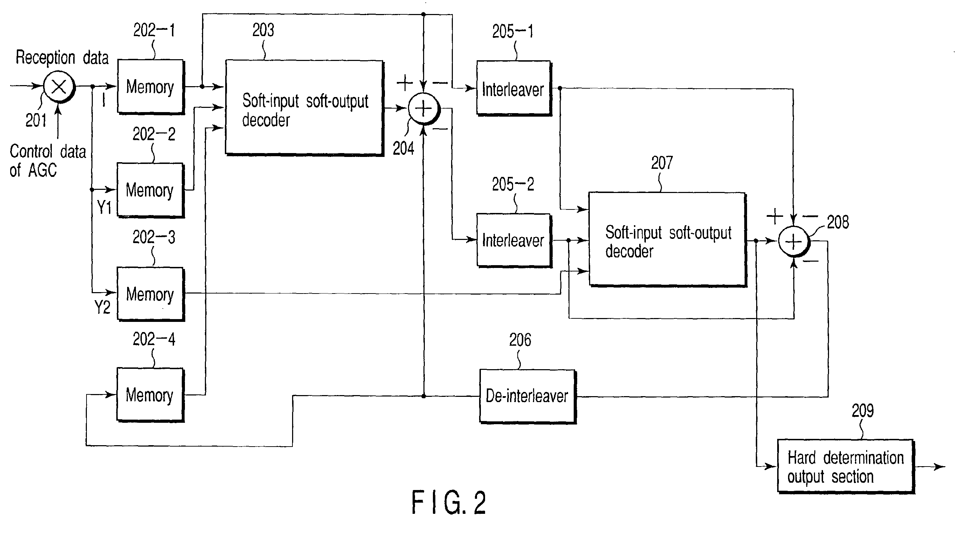

FIG. 2 is a block diagram illustrating the structure of a turbo decoder 108, according to a first embodiment of the invention, which appears in FIG. 1. As shown in FIG. 2, the turbo decoder includes two soft-input/soft-output decoders to enhance its error correction ability. In this embodiment, a multiplier 201 is provided immediately before a memory 202-1 that stores the information bit I of reception data, a memory 202-2 that stores the first parity bit Y1 of the reception data, and a memory 202-3 that stores the second parity bit Y2 of the reception data. In this structure, a signal obtained by multiplying a signal from the RAKE receiver 107 by the control data of the AGC 105 is stored in the memories 202-1, 202-2 and 202-3. At this time, the signal from the RAKE receiver 107 is multiplied by the control data, so that the reception data has a reverse property of the control data.

A first soft-input/soft-output decoder 203 receives, as soft inputs, the outputs of the memories 202-1 and 202-2 and that of a memory 202-4 that stores an extrinsic information, thereby decoding them and outputting a soft-determination result to an adder 204. The adder 204 receives and adds the outputs of the memory 202-1 and the first soft-input/soft-output decoder 203 and that of a de-interleaver 206 that returns, to an original arrangement, a signal rearranged by an interleaver, thereby outputting the addition result to an interleaver 205-2 that executes signal rearrangement.

A second soft-input/soft-output decoder 207 receives, as soft inputs, a signal obtained by rearranging at the interleaver 205-1 the output of the memory 202-1, a signal obtained by rearranging at the interleaver 205-2 the output of the adder 204, and the output of the memory 202-3 that stores the second parity bit Y2 of the reception data, thereby decoding them and outputting the soft-determination result to an adder 208. The adder 208 receives and adds the output of the second soft-input/soft-output decoder 207, a signal obtained by rearranging the output of the memory 202 -1 by an interleaver 205-1, and a signal obtained by rearranging the output of the adder 204 by the interleaver 205-2, thereby outputting the addition result to the de-interleaver 206.

After the first and second soft-input/soft-output decoders 203 and 207 execute decoding a predetermined number of times, a hard-determination output section 209 executes a hard determination and outputs a hard determination output (two level data) corresponding to the soft determination output (multilevel data) of the second soft-input/soft-output decoder 207.

In the above-described first embodiment, control data from the AGC 105 is added to an input to the turbo decoder 108, thereby controlling the weighting process during the calculation of a path metric so as to reduce the influence of noise amplified by the AGC 105. Accordingly, an accurate path metric can be calculated, and hence the error correction ability can be maintained at a high level.

### (Second Embodiment)

The method according to the first embodiment enables accurate calculation of the path metric. However, this method is disadvantageous in that the memories 202-1 - 202-3 of the turbo decoder need to have a large capacity, since a reception signal is multiplied by the control data of the AGC 105, hence the dynamic range is inevitably large. To avoid this, in the second embodiment, the control data of the AGC 105 is input to the soft-input/soft-output decoder 207 that actually calculates the path metric. This structure will now be described in detail.

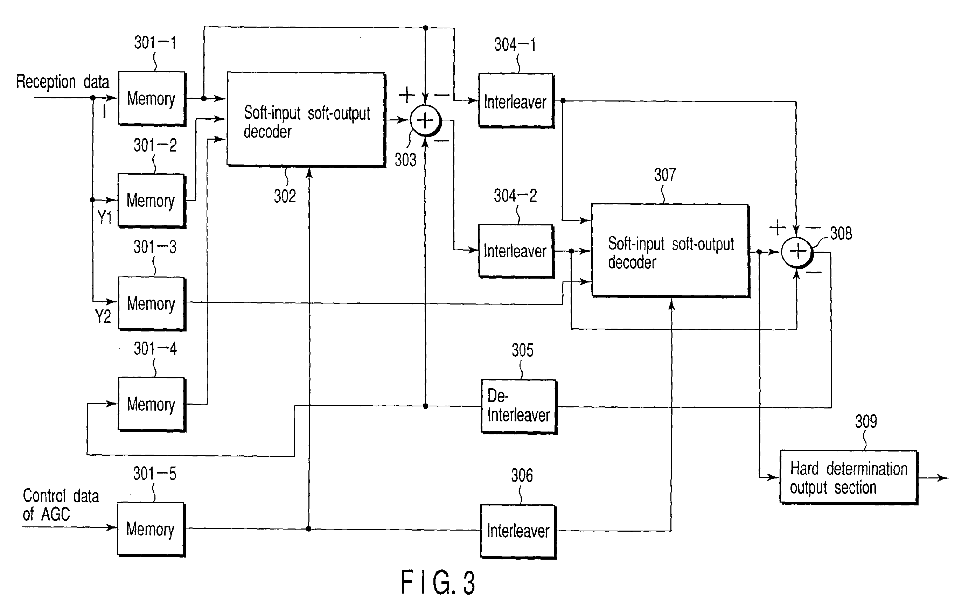

FIG. 3 is a block diagram illustrating the structure of a turbo decoder according to the second embodiment of the invention. The structure of FIG. 3 differs from that of FIG. 2 in that in the former, the multiplier 201 is eliminated, and a memory 301-5 that temporary stores the control data of the AGC 105 and an interleaver 306 that rearranges the control data are added. The other structures of FIG. 3 are the same as those of FIG. 2.

When turbo decoding has been started, reception data is read from memories 301-1 and 301-2 and input to a soft-input/soft-output decoder 302, where the data is decoded. The decoding result of the soft-input/soft-output decoder 302 is supplied via an adder 303 to an interleaver 304-2, where it is rearranged. The rearrangement result is input to the soft-input/soft-output decoder 307.

In parallel with this process, the control data of the AGC 105 is read from the memory 301-5, rearranged by the interleaver 306, and output to the soft-input/soft-output decoder 307, where the control data is decoded together with reception data.

The data decoded by the soft-input/soft-output decoder 307 is input via an adder 308 to a de-interleaver 305 that returns a rearranged signal to its original arrangement. After being processed by the de-interleaver 305, the signal is stored in a memory 301-4 and used as an input to the soft-input/soft-output decoder 302.

After the soft-input/soft-output decoders 302 and 307 execute decoding a predetermined number of times, a hard-determination output section 309 executes a hard determination and outputs a hard determination result.

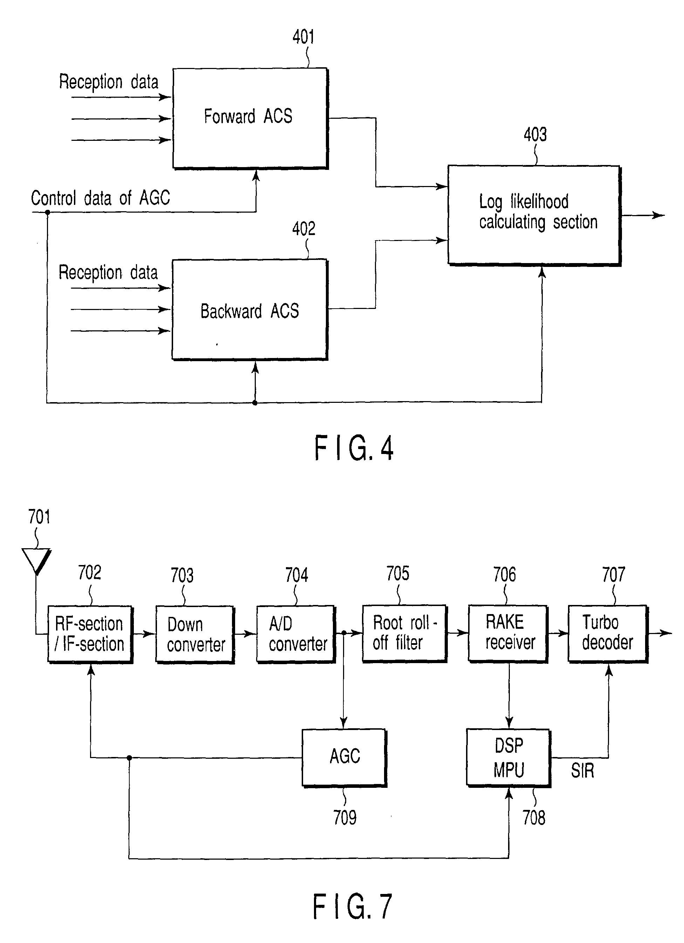

FIG. 4 is a block diagram illustrating the structure of the soft-input/soft-output decoder 302 (307).

Reception data read from the memories 301-1, 301-2 and 301-4 is input to a forward ACS (Add Compare Select) section 401 and a backward ACS section 402. At this time, the control data of the AGC 105 is also input to the forward ACS section 401 and the backward ACS section 402.

The calculation results of the forward ACS section 401 and the backward ACS section 402 are input to a Log likelihood calculating section 403, where they are weighted. At this time, the control data of the AGC 105 is also input to the Log likelihood calculating section 403.

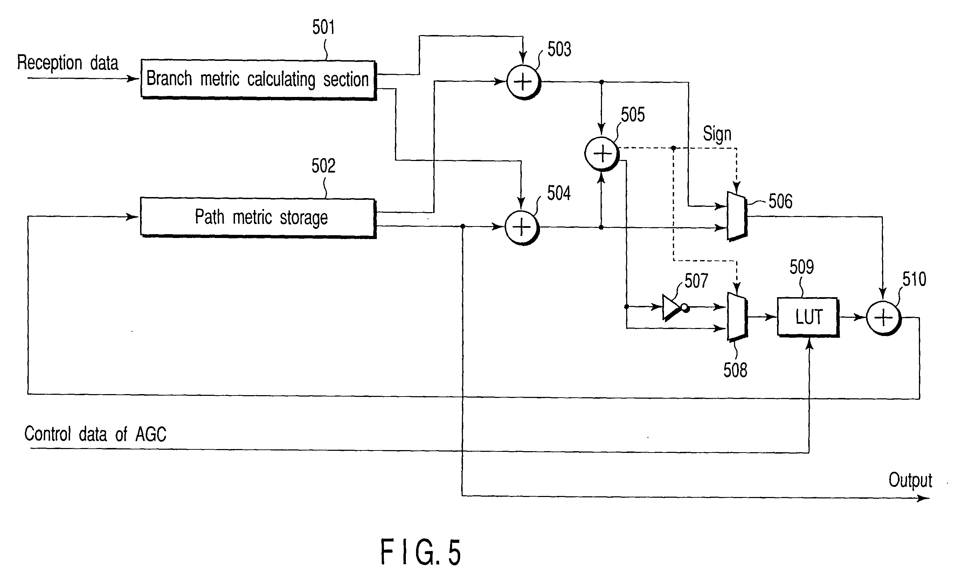

FIG. 5 is a view illustrating the structure of an ACS section commonly employed in the forward ACS section 401 and the backward ACS section 402. Reception data read from the memories 301-1, 301-2 and 301-4 is input to a branch metric calculating section 501, where a branch metric is calculated. The calculated branch metric is input to adders 503 and 504 and added to a path metric stored in a path metric storage 502. The addition result of the adder 503 is supplied to an adder 505 and to one input of a selector 506, while the addition result of the adder 504 is supplied to the adder 505 and to the other input of the selector 506.

The selector 506 selects one of the outputs of the adders 503 and 504, depending upon whether a "Sign" bit, which indicates the plus/minus of the addition result of the adder 505, is "0" or "1", and supplies the selected output to an adder 510. Further, a selector 508 selects one of the output of the adder 505 and data obtained by inverting the output of the adder 505 by an inverter 507, depending upon whether the "Sign" bit, which indicates the plus/minus of the addition result of the adder 505, is "0" or "1", and supplies the selected output to the adder 510. The addition result of the adder 510 is supplied to and stored in the path metric storage 502. The branch metric is calculated sequentially and supplied to the path metric storage 502, where the calculated branch metrics are accumulated and added. The storage result of the storage 502 is extracted as an output.

In this embodiment, the output of the selector 508 is converted using a lookup table (LUT) 509. This conversion is executed by switching the internal conversion tables of the lookup table in accordance with the control data of the AGC 105. This method controls the weighting process executed during the calculation of the path metric, so that the influence of noise amplified by the AGC 105 is reduced.

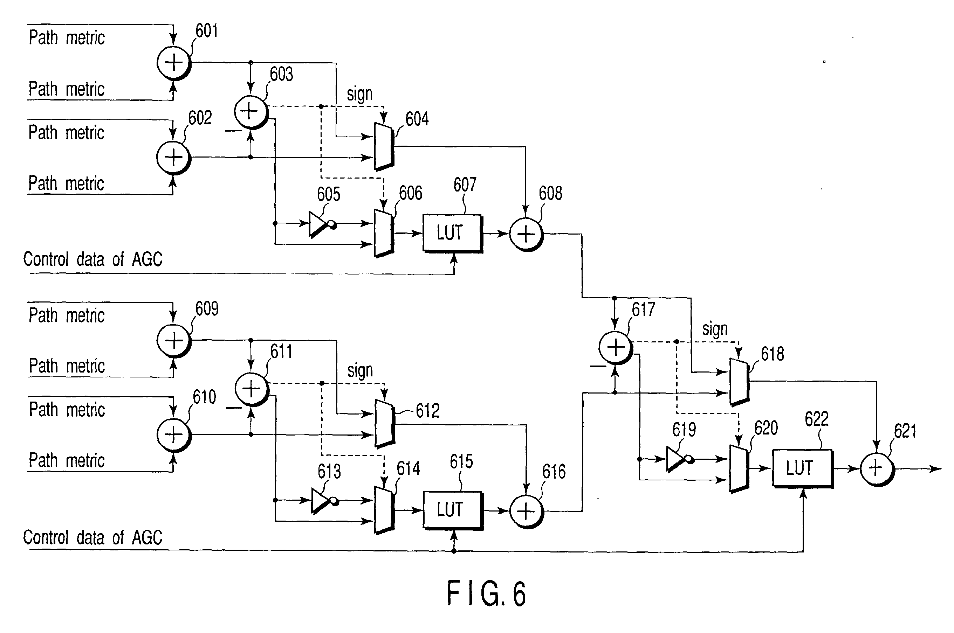

FIG. 6 is a block diagram illustrating the structure of the aforementioned Log likelihood calculating section 403. The path metric output from the path metric storage 502 is input to and added in adders 601 and 602.

The path metric calculated by the forward ACS section 401 is input to and added in the adders 601 and 602. The output of the adder 601 is input to an adder 603 and to one input of a selector 604. The output of the adder 602 is input to the adder 603 and to the other input of the selector 604. The selector 604 selects one of the outputs of the adders 601 and 602, depending upon whether a "Sign" bit, which indicates the plus/minus of the addition result of the adder 603, is "0" or "1", and supplies the selected output to an adder 608. Further, a selector 606 selects one of the output of the adder 603 and data obtained by inverting the output of the adder 603 by an inverter 605, depending upon whether the "Sign" bit, which indicates the plus/minus of the addition result of the adder 603, is "0" or "1", and supplies the selected output to the adder 608.

In this embodiment, the output of the selector 606 is converted using a lookup table (LUT) 607. This conversion is executed by switching the internal conversion tables of the lookup table in accordance with the control data of the AGC 105.

Similarly, the path metric calculated by the backward ACS section 402 is input to and added in the adders 609 and 610. The output of the adder 609 is input to an adder 611 and to one input of a selector 612. The output of the adder 610 is input to the adder 611 and to the other input of the selector 612. The selector 612 selects one of the outputs of the adders 609 and 610, depending upon whether a "Sign" bit, which indicates the plus/minus of the addition result of the adder 611, is "0" or "1", and supplies the selected output to an adder 616. Further, a selector 614 selects one of the output of the adder 611 and data obtained by inverting the output of the adder 611 by an inverter 613, depending upon whether the "Sign" bit, which indicates the plus/minus of the addition result of the adder 611, is "0" or "1", and supplies the selected output to the adder 616.

In this embodiment, the output of the selector 614 is converted using a lookup table (LUT) 615. This conversion is executed by switching the internal conversion tables of the lookup table in accordance with the control data of the AGC 105.

The output of the adder 608 is input to an adder 617 and to one input of a selector 618. The output of the adder 616 is input to the adder 617 and to the other input of the selector 618. The selector 618 selects one of the outputs of the adders 608 and 616, depending upon whether a "Sign" bit, which indicates the plus/minus of the addition result of the adder 617, is "0" or "1", and supplies the selected output to an adder 621. Further, a selector 620 selects one of the output of the adder 617 and data obtained by inverting the output of the adder 617 by an inverter 619, depending upon whether the "Sign" bit, which indicates the plus/minus of the addition result of the adder 617, is "0" or "1", and supplies the selected output to the adder 621.

In this embodiment, the output of the selector 620 is converted using a lookup table (LUT) 622. This conversion is executed by switching the internal conversion tables of the lookup table in accordance with the control data of the AGC 105.

This method controls the weighting process executed during the calculation of the path metric, so that the influence of noise amplified by the AGC 105 reduces. Accordingly, the second embodiment can calculate an accurate path metric without increasing the dynamic range of reception data, thereby maintaining its error correction ability at a high level.

### (Third Embodiment)

FIG. 7 shows the structure of a third embodiment. An antenna 701, an RF/IF section 702, a down converter 703, an A/D converter 704, a root roll-off filter 705, a RAKE receiver 706, a turbo decoder 707 and an AGC 709, employed in the third embodiment, are similar to the antenna 101, the RF-section/IF-section 102, the down converter 103, the A/D converter 104, the root roll-off filter 106, the RAKE receiver 107, the turbo decoder 108 and the AGC 105 shown in FIG. 1, respectively. However, the third embodiment is characterized by further comprising a DSP/MPU 708 that calculates a signal-to-interference ratio (SIR) on the basis of the control data of the AGC 709 and transmission power measured by the RAKE receiver 706, and inputting it to the turbo decoder 707.

The SIR signal obtained by the above method is referred to, during an error correction process, by the turbo decoder 707 of a structure as described in the first or second embodiment.

The third embodiment can calculate a more accurate path metric than the first or second embodiment.

As described above in detail, the present invention provides an error correction apparatus capable of accurately calculating a path metric during a decoding process, thereby maintaining its error correction ability at a high level.

## Claims

1. An error correction apparatus **characterized by** comprising:
a receiving section (101) configured to receive a signal;
an amplifier section (102) configured to amplify the received signal received by the receiving section (101);
an automatic gain control section (105) configured to generate a control signal and to control a gain of the amplifier section (102) based on the generated control signal, so as to maintain the amplified received signal at a predetermined level; and
a turbo decoder (108) configured to execute an error correction process on the received signal to thereby output a decoding result of the executed received signal based on the generated control signal.

2. The error correction apparatus according to claim 1, the turbo decoder including a decoding section and a multiplication section (201) coupled to the decoding section, configured to multiply the received signal by the generated control signal, so that the received signal has a reverse property of the generated control signal before the received signal is supplied to the decoding section of the turbo decoder.

3. The error correction apparatus according to claim 1, **characterized in that** the turbo decoder including a calculating section configured to calculate a path metric of the received signal, and an outputting section configured to output a decoding result of the received signal based on the calculated path metric, and a plurality of lookup tables (509) related to a weighting process executed when calculating the path metric, the lookup tables (509) being switched in accordance with the generated control signal to thereby change a weight used to calculate the path metric.

4. The error correction apparatus according to claim 1, **characterized by** further comprising a reception power calculating section (708) configured to calculate a reception power of the received signal, and an SIR estimating section (708) configured to estimate a signal-to-interference ratio (SIR) of the received signal on the basis of the calculated reception power and by the generated control signal, the turbo decoder (707) outputting a decoding result of the received signal, on the basis of the estimated SIR.
